# EUROPEAN PATENT SPECIFICATION

(11) **EP 0 941 589 B1**
(45) Date of publication and mention of the grant of the patent: **17.11.2004**
(21) Application number: 97945804.9
(22) Date of filing: 02.12.1997
(51) Int. Cl.: H04J 3/06, H03L 7/06

(54) **A METHOD AND A CIRCUIT FOR GENERATING A SYSTEM CLOCK SIGNAL**
VERFAHREN UND SCHALTUNG ZUR ERZEUGUNG EINES SYSTEM-TAKTSIGNALS
PROCEDE ET CIRCUIT POUR PRODUIRE UN SIGNAL D'HORLOGE DE SYSTEME

(30) Priority: 04.12.1996 DK 138196
(43) Date of publication of application: 15.09.1999
(73) Proprietor: TELLABS DENMARK A/S, 2750 Ballerup (DK)
(72) Inventor: NIELSEN, Anders, Boje, DK-2740 Skovlunde (DK)
(74) Representative: Boesen, Johnny Peder
(86) International application number: PCT/DK1997/000548
(87) International publication number: WO 1998/025367

(56) References cited:
- EP-A- 0 718 995
- GB-A- 2 257 603

## Description

The invention relates to a method of generating a system clock signal which may periodically be locked to a selected one of a plurality of phase-locked loops which each emit a clock signal in phase-locked relationship with an external reference signal, each of said phase-locked loops comprising a numerically controlled oscillator which generates the clock signal of the loop by dividing the system clock signal.

The invention moreover relates to a circuit for generating a system clock signal and comprising a central module having a system clock generator as well as a plurality of external modules each having a phase-locked loop having a numerically controlled oscillator. The numerically controlled oscillator is capable of generating a clock signal in phase-locked relationship with an external reference signal by division of the system clock signal, and the system clock signal may periodically be locked to a selected one of the phase-locked loops.

Synchronous telecommunications systems, such as e.g. an SDH network (Synchronous Digital Hierarchy), consist of a large number of network elements which each comprise a system clock generator which generates an internal clock signal to control the network element. An SDH network element may e.g. have an internal system clock generator of 77.76 MHz. This will typically be phase-locked to an 8 kHz signal derived from the received data, said 8 kHz corresponding to the frame frequency of the transmitted communications signals. For example, it is possible to lock to data received from another network element, or to one of the lower order signals, e.g. a PDH signal, which the network element receives with a view to introducing these into the SDH structure. Thus, each network element has its own system clock generator, typically a phase-locked loop (PLL).

The individual network elements, which may e.g. be multiplexers or Add/Drop multiplexers, will frequently serve to multiplex a large number of plesiochronous channels, e.g. 2 Mbits/s channels, into the SDH system. In principle, each of these 2 Mbits/s channels will have its own clock which is independent of the other channels and of the SDH system. Although the clock frequency of each channel will be close to the others, since all of them are produced as multiples of 8 kHz, but not necessarily the same 8 kHz source, their mutual phase may vary freely.

GB 2 257 603 shows an example of an SDH system in which an SDH network element including a desynchronizer can be synchronized to a 2 Mbit timing clock.

It is desirable that such a network element is capable of locking its system clock to an arbitrary one of the plesiochronous channels to which it is connected, and the invention relates to such locking.

Typically, each input gate or module, which receives a plesiochronous channel, will be provided with a phase-locked loop which generates a clock signal corresponding thereto on the basis of the received data. It is known to transfer each of these clock signals to a central system clock unit which can then lock to an arbitrary one of these clock signals. However, it takes a large bandwidth to transfer the many clock signals from the individual modules to the central clock unit, and it moreover means that a phase jump will typically occur when the central clock unit switches from one clock signal to another. Such a phase jump may cause the network to get out of synchronization, and is therefore undesirable.

Accordingly, an object of the invention is to provide a method of the type stated in the opening paragraph, which requires a smaller bandwidth between the individual modules and the central clock unit, and which enables switching from one module to another without a phase jump in the system clock signal.

This is achieved according to the invention in that a digital error signal, which indicates a phase difference between the clock signal of the loop and the external reference signal of the loop, is transferred from the selected phase-locked loop to a central numerically controlled oscillator, and that the system clock signal is locked to the output signal from the central numerically controlled oscillator.

When just the digital error signal is transferred, a considerable saving in bandwidth is achieved, as this varies with a much smaller frequency than the clock signal itself. Further, the central numerically controlled oscillator will serve as a slave of the corresponding oscillator in the selected loop, and when switching to another loop it will merely instead receive the error signal from the new loop, so that a phase jump will not occur in its output signal and thus not in the system clock signal either.

As stated in claim 2, it will be expedient that the central numerically controlled oscillator operates in the same manner as the numerically controlled oscillators in the phase-locked loops. This will be expedient in particular if all the phase-locked loops have substantially the same frequency.

A further saving in bandwidth may be achieved when, as stated in claim 3, the digital error signal from the selected loop is integrated over a period of time before it is transferred to the central numerically controlled oscillator.

As mentioned, the invention moreover relates to a circuit for generating a system clock signal of the stated type. When the central module comprises a numerically controlled oscillator, and each of the phase-locked loops is adapted to transfer a digital error signal, which indicates a phase difference between the clock signal of the loop and the external reference signal of the loop, to the central numerically controlled oscillator, and when the system clock generator is adapted to lock the system clock signal to the central numerically oscillator, then, as mentioned above, a saving in bandwidth is achieved and no phase jump occurs when switching to another loop.

As stated in claim 5, each of the numerically controlled oscillators may comprise a programmable divider which is adapted to divide the system clock signal by a factor determined by the digital signal, and, as stated in claim 6, it will moreover be expedient that the central numerically controlled oscillator is arranged in the same manner as the numerically controlled oscillators in the phase-locked loops.

As stated in claim 7, a further saving in bandwidth may be achieved in that each of the phase-locked loops moreover comprises means for integrating the digital error signal of the loop over a period of time before it is transferred to the central numerically controlled oscillater. As stated in claim 8, these means may expediently comprise a counter capable of counting the number of times the programmable divider has divided the system clock signal by a specific factor within a given period of time. Then, it suffices to transfer the count once for each period.

The circuit will be particularly useful for an SDH system when, as stated in claim 9, the system clock signal has a frequency of approximately 77.76 MHz. When, as stated in claim 10, the clock signal of each of the phase-locked loops has a frequency of approximately 2.048 MHz, the system is particularly useful for 2.048 Mbits/s channels, which are mainly used in Europe, while, when the clock signal of the phase-locked loops has a frequency of approximately 1.544 MHz, as stated in claim 11, it is particularly useful for 1.544 Mbits/s channels, which are mainly used in North America.

The invention will now be described more fully below with reference to the drawing, in which
fig. 1 shows an example of a known system clock generator,
fig. 2 shows an embodiment of the invention in which a digital error signal is transferred from a module to a central numerically controlled oscillator, and
fig. 3 shows a variant of an external module.

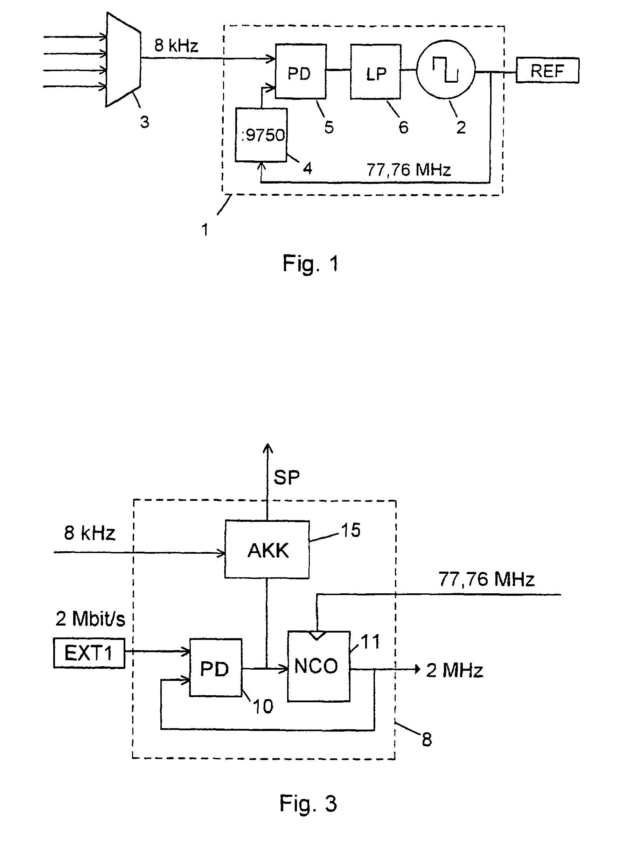

Fig. 1 shows an example of a system clock generator 1 in a network element in an SDH network. A controlled oscillator 2 generates a clock signal of 77.76 MHz, which may then be used as a system clock signal in the network element concerned. Usually, it is desired to phase-lock this clock signal to an external signal of 8 kHz, which corresponds to the frame frequency of the SDH system, and which will typically be derived from one of the arriving data signals.

The selector 3 is adapted to select one of a plurality of 8 kHz signals which may come from various sources. One of the signals may e.g. be derived from SDH signals received from another network element in the SDH network, while others may be derived from plesiochronous channels of e.g. 2, 34 or 140 Mbits/s, which are fed to the network element to be introduced into the SDH system. In all cases, the derived signals will be divided to a signal of 8 kHz. It may thus be decided through the selector 3 to which signal the system clock generator is to be locked.

The output signal from the oscillator 2 is divided in the divider circuit 4 to a signal of 8 kHz, and then it is fed to a phase detector 5 together with the 8 kHz signal selected in the selector 3. The phase detector compares the phase of the two signals, and the result is lowpass filtered in the lowpass filter 6, following which it is used as a control signal for the oscillator 2. The mode of operation of this circuit is prior art and will therefore not be described more fully.

In the event of locking to e.g. a 2 Mbits/s channel, a large number of different such channels will typically be present in a network element, and it is desirable that the element can lock to an arbitrary one of these channels, and the invention addresses this situation.

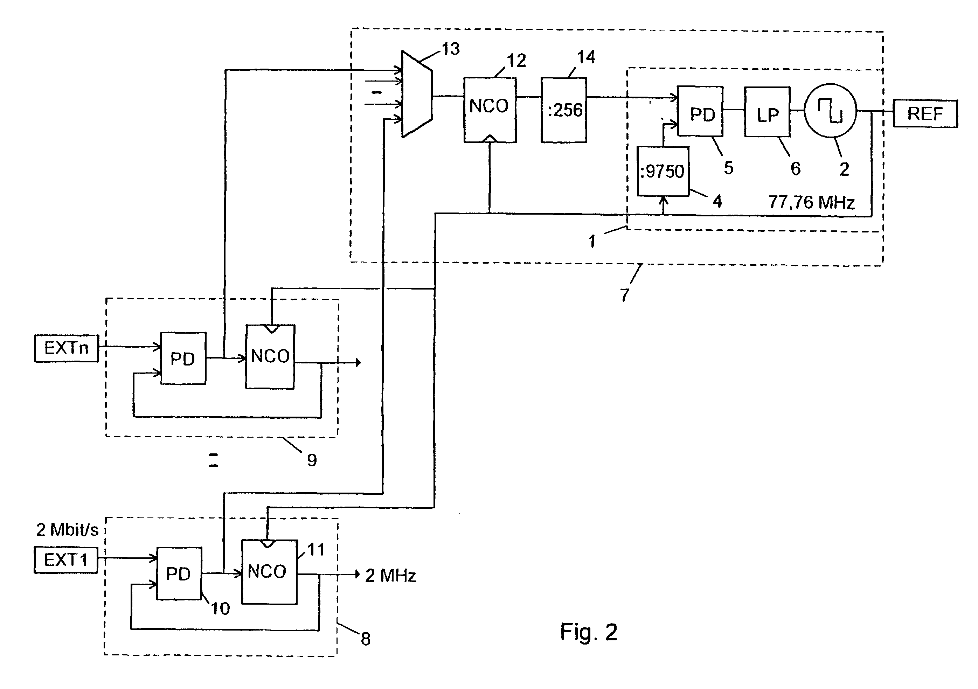

Fig. 2 shows an example of an embodiment of the invention. The system clock generator 1, which is the same as in fig. 1, is placed on a central module 7, while for each 2 Mbits/s channel there is an external module, of which the two modules 8 and 9 are shown here.

Each of the external modules contains a clock regeneration circuit, which consists of a digital phase-locked loop having a phase detector 10 and a numerically controlled oscillator (NCO) 11. This circuit regenerates a clock signal of 2 MHz from an arriving data signal (e.g. EXT1) of 2 Mbits/s. These numerical statements are approximate, since in reality a clock signal of 2.048 MHz will be involved. The numerically controlled oscillator is designed as a programmable divider which divides the system clock signal of the 77.76 MHz. Theoretically, the division ratio should be 77.76/2.048 = 37.97, and the divider 11 is therefore adapted to be capable of dividing by a factor of 37, 38 or 39 depending on a control signal which may assume the values {-1,0,1}. The phase detector 10 is therefore adapted to emit one of these values depending on the phase difference between the arriving signal and the regenerated clock signal, and the control signal is therefore also called an error signal.

According to the prior art, locking to an arbitrary one of the many channels would require feeding each of the regenerated 2 MHz clock signals to the central module 7, where one of them would be selected and, after division to 8 kHz, be fed to the system clock generator 1, as shown in fig. 1. However, it requires a considerable bandwidth to transfer the many 2 MHz signals, and moreover a phase jump would occur when switching from one channel to another.

Instead, in the shown embodiment of the invention, a numerically controlled oscillator or divider 12, which may be quite similar to the oscillators 11 placed on the external modules, is arranged on the central module 7, and then just the error signal from each external module is transferred to the central divider 12. The central divider 12 will thus follow the divider 11 on the selected module closely, as they receive exactly the same error signal. A selector 13 connects the selected error signal to the divider 12.

When switching from one module to another, the divider 12 merely receives a new error signal, but will otherwise not be affected, and thus no phase jump will occur in the signal which is fed to the system clock generator 1. This signal is divided in the divider circuit 14 from 2 MHz to 8 kHz before being fed to the system clock generator, as described above for fig. 1.

The above description relates to a situation in which a plurality of 2 Mbits/s channels are introduced into an SDH system. The same circuit may also be used when e.g. 1.5 Mbits/s channels are involved. In that case, the regenerated clock signal is of 1.544 MHz, and the division ratio of the programmable divider should be 77.76/1.544 = 50.36 in theory. In this case, the divider is therefore arranged to be capable of dividing by a factor of 50 or 51 depending on the error signal, which may here assume the values (0, 1}.

Fig. 3 shows a variant of the external module 8. Instead of currently transferring the error signal to the central module 7 like in fig. 2, the values are here accumulated in an accumulator 15. The accumulator may e.g. be an 8-bit counter which counts the number of times the programmable counter 11 has counted to 37 or 39 (for 2 Mbits/s) or 50 (for 1.5 Mbits/s) within a specific period of time. In this example, the count, also called synchronization pointer (SP), is transferred to the central module 7 once for each SDH frame, and the counter 15 is therefore controlled by an 8 kHz signal, which transfers SP and then resets the counter. Additional bandwidth is saved hereby, since it is just necessary to transfer a byte (SP) for each frame period.

In the 2 Mbits/s case, the count (SP) of the counter 15 is increased by 1 (i.e. SP = SP + 1) when the divider 11 divides by 37. It is maintained unchanged (i.e. SP = SP + 0) when the divider 11 divides by 38, and it is reduced by one 1 (i.e. SP = SP - 1) when the divider 11 divides by 39. As the theoretical division ratio 37,97 is close to 38, the divider 11 will divide by 38 in the vast majority of cases, and the count will therefore assume a value as low as 8 for a period at nominal frequencies, and, when the frequencies vary, it will be within the range 0-16. In this case, a 4-bit counter will thus be sufficient.

In case of a 1.5 Mbits/s channel, the count (SP) of the counter 15 is increased by 1 (i.e. SP = SP + 1) when the divider 11 divides by 50, and it is maintained unchanged (i.e. SP = SP + 0) when the divider 11 divides by 51. Here the count will assume the value 123 for a period at nominal frequencies, and a counter of 7 or 8 bits has to be used.

On the central module 7, the SP value is fed from the selected module to the divider 12 which, in the subsequent period, adjusts its division ratio to the SP value just received.

Although a preferred embodiment of the present invention has been described and shown, the invention is not restricted to it, but may also be embodied in other ways within the scope of the subject-matter defined in the appended claims.

## Claims

1. A method of generating a system clock signal which may periodically be locked to a selected one of a plurality of phase-locked loops which each emit a clock signal in phase-locked relationship with an external reference signal, each of said phase-locked loops comprising a numerically controlled oscillator (11) which generates the clock signal of the loop by dividing the system clock signal, **characterized in that** a digital error signal, which indicates a phase difference between the clock signal of the loop and the external reference signal of the loop, is transferred from the selected phase-locked loop to a central numerically controlled oscillator (12), and that the system clock signal is locked to the output signal from the central numerically controlled oscillator (12).

2. A method according to claim 1, **characterized in that** the central numerically controlled oscillator (12) operates in the same manner as the numerically controlled oscillators (11) in the phase-locked loops.

3. A method according to claim 1 or 2, **characterized in that** the digital error signal from the selected loop is integrated over a period of time before it is transferred to the central numerically controlled oscillator (12).

4. A circuit for generating a system clock signal, said circuit comprising a central module (7) having a system clock generator (1) and a plurality of external modules (8, 9) each having a phase-locked loop, wherein each of the phase-locked loops comprises a numerically controlled oscillator (11) capable of generating a clock signal in phase-locked relationship with an external reference signal by division of the system clock signal, and wherein the system clock signal may periodically be locked to a selected one of the phase-locked loops, **characterized in that** the central module (7) comprises a numerically controlled oscillator (12), that each of the phase-locked loops is adapted to transfer a digital error signal, which indicates a phase difference between the clock signal of the loop and the external reference signal of the loop, to the central numerically controlled oscillator (12), and that the system clock generator (1) is adapted to lock the system clock signal to the central numerically controlled oscillator (12).

5. A circuit according to claim 4, **characterized in that** each of the numerically controlled oscillators (11) comprises a programmable divider which is adapted to divide the system clock signal by a factor determined by the digital error signal.

6. A circuit according to claim 4 or 5, **characterized in that** the central numerically controlled oscillator (12) is arranged in the same manner as the numerically controlled oscillators (11) in the phase-locked loops.

7. A circuit according to claim 5, **characterized in that** each of the phase-locked loops moreover comprises means (15) for integrating the digital error signal of the loop over a period of time before it is transferred to the central numerically controlled oscillator (12).

8. A circuit according to claim 7, **characterized in that** said integrating means (15) comprise a counter capable of counting the number of times the programmable divider has divided the system clock signal by a specific factor within a given period of time.

9. A circuit according to claims 4-8, **characterized in that** the system clock signal has a frequency of approximately 77.76 MHz.

10. A circuit according to claims 4-9, **characterized in that** the clock signal of each of the phase-locked loops has a frequency of approximately 2.048 MHz.

11. A circuit according to claims 4-9, **characterized in that** the clock signal of each of the phase-locked loops has a frequency of approximately 1.544 MHz.

## Patentansprüche

1. Verfahren zur Erzeugung eines Systemtaktsignals, das mit einer ausgewählten einer Mehrzahl von Phasenregelschleifen periodisch gerastet werden kann, die jeweils ein Taktsignal in phasengerasteter Beziehung mit einem externen Bezugssignal aussenden, wobei jede der Phasenregelschleifen einen numerisch gesteuerten Oszillator (11) umfasst, der das Taktsignal der Schleife durch Teilen des Systemtaktsignals erzeugt, **dadurch gekennzeichnet, dass** ein digitales Fehlersignal, das einen Phasenunterschied zwischen dem Taktsignal der Schleife und dem externen Bezugssignal der Schleife anzeigt, von der ausgewählten Phasenregelschleife zu einem zentralen numerisch gesteuerten Oszillator (12) übertragen wird und dass das Systemtaktsignal mit dem Ausgangssignal von dem zentralen numerisch gesteuerten Oszillator (12) gerastet wird.

2. Verfahren nach Anspruch 1, **dadurch gekennzeichnet, dass** der zentrale numerisch gesteuerte Oszillator (12) auf dieselbe Weise arbeitet wie die numerisch gesteuerten Oszillatoren (11) in den Phasenregelschleifen.

3. Verfahren nach Anspruch 1 oder 2, **dadurch gekennzeichnet, dass** das digitale Fehlersignal von der ausgewählten Schleife über einen Zeitraum integriert wird, bevor es zum zentralen numerisch gesteuerten Oszillator (12) übertragen wird.

4. Schaltung zur Erzeugung eines Systemtaktsignals, wobei die Schaltung ein zentrales Modul (7) mit einem Systemtaktgenerator (1) und eine Mehrzahl von externen Modulen (8, 9) umfasst, wobei jedes eine Phasenregelschleife aufweist, wobei jede der Phasenregelschleifen einen numerisch gesteuerten Oszillator (11) umfasst, der ein Taktsignal in phasengerasteter Beziehung mit einem externen Bezugssignal durch Teilung des Systemtaktsignals erzeugen kann, und wobei das Systemtaktsignal mit einer ausgewählten der Phasenregelschleifen periodisch gerastet werden kann, **dadurch gekennzeichnet, dass** das zentrale Modul (7) einen numerisch gesteuerten Oszillator (12) umfasst, dass jede der Phasenregelschleifen angepasst ist, um ein digitales Fehlersignal, das einen Phasenunterschied zwischen dem Taktsignal der Schleife und dem externen Bezugssignal der Schleife anzeigt, zu dem zentralen numerisch gesteuerten Oszillator (12) zu übertragen, und dass der Systemtaktgenerator (1) angepasst ist, um das Systemtaktsignal mit dem zentralen numerisch gesteuerten Oszillator (12) zu rasten.

5. Schaltung nach Anspruch 4, **dadurch gekennzeichnet, dass** jeder der numerisch gesteuerten Oszillatoren (11) einen programmierbaren Teiler umfasst, der angepasst ist, um das Systemtaktsignal durch einen Faktor zu teilen, der durch das digitale Fehlersignal bestimmt ist.

6. Schaltung nach Anspruch 4 oder 5, **dadurch gekennzeichnet, dass** der zentrale numerisch gesteuerte Oszillator (12) auf dieselbe Weise wie die numerisch gesteuerten Oszillatoren (11) in den Phasenregelschleifen angeordnet ist.

7. Schaltung nach Anspruch 5, **dadurch gekennzeichnet, dass** jede der Phasenregelschleifen außerdem eine Einrichtung (15) zur Integration des digitalen Fehlersignals der Schleife über einen Zeitraum umfasst, bevor es zum zentralen numerisch gesteuerten Oszillator (12) übertragen wird.

8. Schaltung nach Anspruch 7, **dadurch gekennzeichnet, dass** die Integrationseinrichtungen (15) einen Zähler umfassen, der die Anzahl von Malen zählen kann, die der programmierbare Teiler innerhalb eines vorgegebenen Zeitraums das Systemtaktsignal durch einen speziellen Faktor geteilt hat.

9. Schaltung nach den Ansprüchen 4-8, **dadurch gekennzeichnet, dass** das Systemtaktsignal eine Frequenz von ungefähr 77,76 MHz aufweist.

10. Schaltung nach den Ansprüchen 4-9, **dadurch gekennzeichnet, dass** das Taktsignal von jeder der Phasenregelschleifen eine Frequenz von ungefähr 2,048 MHz aufweist.

11. Schaltung nach den Ansprüchen 4-9, **dadurch gekennzeichnet, dass** das Taktsignal von jeder der Phasenregelschleifen eine Frequenz von ungefähr 1,544 MHz aufweist.

## Revendications

1. Procédé de production d'un signal d'horloge de système qui peut être verrouillé périodiquement sur une boucle sélectionnée parmi une pluralité de boucles à verrouillage de phase, chacune émettant un signal d'horloge en relation de verrouillage de phase avec un signal de référence externe, chacune desdites boucles à verrouillage de phase comprenant un oscillateur à commande numérique (11) qui produit le signal d'horloge de la boucle en divisant le signal d'horloge de système, **caractérisé en ce qu'**un signal d'erreur numérique, qui indique un déphasage entre le signal d'horloge de la boucle et le signal de référence externe de la boucle, est transféré de la boucle à verrouillage de phase sélectionnée vers un oscillateur central à commande numérique (12), et **en ce que** le signal d'horloge de système est verrouillé sur le signal de sortie émis par l'oscillateur central à commande numérique (12).

2. Procédé selon la revendication 1, **caractérisé en ce que** l'oscillateur central à commande numérique (12) fonctionne de la même manière que les oscillateurs à commande numérique (11) dans les boucles à verrouillage de phase.

3. Procédé selon la revendication 1 ou 2,
**caractérisé en ce que** le signal d'erreur numérique de la boucle sélectionnée est intégré sur une durée avant d'être transféré vers l'oscillateur central à commande numérique (12).

4. Circuit pour produire un signal d'horloge de système, ledit circuit comprenant un module central (7) ayant un générateur d'horloge de système (1) et une pluralité de modules externes (8, 9), chacun ayant une boucle à verrouillage de phase, dans lequel chacune des boucles à verrouillage de phase comprend un oscillateur à commande numérique (11) capable de produire un signal d'horloge en relation de verrouillage de phase avec un signal de référence externe en divisant le signal d'horloge de système, et dans lequel le signal d'horloge de système peut être verrouillé périodiquement sur une boucle sélectionnée parmi les boucles à verrouillage de phase, **caractérisé en ce que** le module central (7) comprend un oscillateur central à commande numérique (12), **en ce que** chacune des boucles à verrouillage de phase est adaptée pour transférer un signal d'erreur numérique, qui indique un déphasage entre le signal d'horloge de la boucle et le signal de référence externe de la boucle, vers l'oscillateur central à commande numérique (12), et **en ce que** le générateur d'horloge de système (1) est adapté pour verrouiller le signal d'horloge de système sur l'oscillateur central à commande numérique (12).

5. Circuit selon la revendication 4, **caractérisé en ce que** chacun des oscillateurs à commande numérique (11) comprend un diviseur programmable qui est adapté pour diviser le signal d'horloge de système par un facteur déterminé par le signal d'erreur numérique.

6. Circuit selon la revendication 4 ou 5, **caractérisé en ce que** l'oscillateur central à commande numérique (12) est agencé de la même manière que les oscillateurs à commande numérique (11) dans les boucles à verrouillage de phase.

7. Circuit selon la revendication 5, **caractérisé en ce que** chacune des boucles à verrouillage de phase comprend en outre un moyen (15) pour intégrer le signal d'erreur numérique de la boucle sur une durée avant de le transférer vers l'oscillateur central à commande numérique (12).

8. Circuit selon la revendication 7, **caractérisé en ce que** ledit moyen d'intégration (15) comprend un compteur capable de compter le nombre de fois où le diviseur programmable a divisé le signal d'horloge de système par un facteur spécifique pendant une durée donnée.

9. Circuit selon les revendications 4 à 8, **caractérisé en ce que** le signal d'horloge de système a une fréquence d'environ 77,76 MHz.

10. Circuit selon les revendications 4 à 9, **caractérisé en ce que** le signal d'horloge de chacune des boucles à verrouillage de phase a une fréquence d'environ 2,048 MHz.

11. Circuit selon les revendications 4 à 9, **caractérisé en ce que** le signal d'horloge de chacune des boucles à verrouillage de phase a une fréquence d'environ 1,544 MHz.
